Europäisches Patentamt

European Patent Office

Office européen des brevets

(19)

(11) **EP 1 333 583 A1**

(12) **EUROPÄISCHE PATENTANMELDUNG**

(43) Veröffentlichungstag:
**06.08.2003 Patentblatt 2003/32**

(51) Int Cl.[7]: **H03M 7/00**

(21) Anmeldenummer: **01130334.4**

(22) Anmeldetag: **19.12.2001**

| | |
|---|---|
| (84) Benannte Vertragsstaaten:<br>**AT BE CH CY DE DK ES FI FR GB GR IE IT LI LU MC NL PT SE TR**<br>Benannte Erstreckungsstaaten:<br>**AL LT LV MK RO SI** | (71) Anmelder: **SIEMENS AKTIENGESELLSCHAFT**<br>**80333 München (DE)**<br><br>(72) Erfinder: **Jelonnek, Bjoern, Dr.**<br>**89079 Ulm (DE)** |

(54) **Breitbandiger Sigma-Delta-Modulator**

(57)     Sigma-Delta-Modulator zur Wandlung von digitalen Eingangssignalen x(k) umfassend eine erste Rückkoppelschleife eines spektral geformten Ausgangssignals y(k) des Sigma-Delta-Modulators und eine zweite Rückkoppelschleife eines spektral geformten Differenzsignals e(k) aus einem intermediären Signal u(k) und dem Ausgangssignal y(k),
wobei das intermediäre Signal u(k) das Differenzsignal des Eingangssignals x(k) und dem Summensignal r(k) der ersten und zweiten Rückkoppelschleifen ist, wobei ein Quantisierer (Q) basierend auf dem intermediären Signal u(k) das Ausgangssignal y(k) bestimmt, wobei k die diskrete unabhängige Zeitvariable ist. Erfindungsgemäß umfasst der Sigma-Delta-Wandler Mittel (Z) zur Erzeugung eines Laufzeitunterschiedes zwischen dem Ausgangssignal y(k) und dem Eingangssignal x(k).

## FIG 2

**Beschreibung**

Die Erfindung betrifft einen Sigma-Delta-Modulator zur Wandlung von breitbandigen digitalen Eingangssignalen nach dem Oberbegriff des Anspruchs 1.

In Digital-zu-Analog-Wandlern, wie sie zum Beispiel in digitalen Funkkommunikationssystemen eingesetzt werden, wird üblicherweise ein digitales Eingangssignal mit $2^N$ Signalzuständen und einer festen Abtastfrequenz $f_a$ in ein analoges Signal überführt, dass im Frequenzbereich $-f_a/2$ bis $+f_a/2$ möglichst gut mit dem digitalen Signal übereinstimmen soll.

Insbesondere bei hohen Bitbreiten N stellt die durch analoge Schaltungstechnik zu realisierende Anzahl von Signalzuständen ein wesentliches Problem dar. Aus diesem Grund wird das digitale Signal durch digitale Filter interpoliert und es werden sogenannte Sigma-Delta-Modulatoren in den Digital-zu-Analog-Wandlern eingesetzt, weche die Bitbreite des digitalen Signals bei erhöhter Abtastfrequenz deutlich reduzieren und das dadurch erhöhte Quantisierungsrauschen in bisher ungenutzte Frequenzbereiche transformieren. Besonders effizient sind hierbei Strukturen von Sigma-Delta-Modulatoren, die eine Formung des Rauschsignals durch IIR-Filter (Infinite-Impulse-Response-Filter) höherer Ordnung erzielen.

Ein Digital-zu-Analog-Wandler unter Verwendung eines IIR-Filters als Interpolierglied und eines oder mehrerer Sigma-Delta-Modulatoren zur Umsetzung der interpolierten Signale ist beispielsweise in der US 5 786 779 beschrieben.

Ein kaskadierter Sigma-Delta-Modulator für einen Digital-Analogwandler ist ferner in der DE 197 22 434 C1 aufgezeigt. Eine ausführliche Darstellung des Aufbaus und der Wirkungsweise von Sigma-Delta-Modulatoren wird in S.R. Norswothy, R. Schreier, G. Temes: "Delta-Sigma Data Converters, Theory, Design and Simulation", IEEE Press 1997, ISBN 0-7803-1045-4, gegeben.

Bei den Sigma-Delta-Modulatoren existieren nun zwei Ansätze, um eine Rauschformung zu erreichen:

Nach einem ersten Ansatz werden Rückkoppelschleifen höherer Ordnung eingesetzt, welche eine Reduktion auf bis zu zwei Signalzuständen erlauben (1-Bit-Signaltechnik). Jedoch ab einer Rauschformung der Ordnung 3 können diese zu möglichen Instabilitäten bei hohen Eingangssignalen führen; es treten sehr leicht Überhöhungen des Wertebereiches interner Zustandsspeicher auf. Um dem zu begegnen, werden in der Praxis ein in der Amplitude verringertes Eingangssignal sowie Zustandsspeicher mit Clipping-Eigenschaften verwendet, wodurch sich eine empirisch ermittelbare Stabilität der Schaltung erreichen lässt.

Nach einem zweiten Ansatz werden kaskadierte Strukturen erster und/oder zweiter Ordnung eingesetzt, die mehrstufig sind und dadurch ein stabiles Betriebsverhalten aufweisen.

Der Sigma-Delta-Modulator zur Wandlung von digitalen Eingangssignalen x(k) kann eine erste Rückkoppelschleife eines spektral geformten Ausgangssignals y(k) des Sigma-Delta-Modulators und eine zweite Rückkoppelschleife eines spektral geformten Differenzsignals e(k) aus einem intermediären Signal u(k) und dem Ausgangssignal y(k) umfassen, wobei das intermediäre Signal u(k) das Differenzsignal des Eingangssignals x(k) und dem Summensignal r(k) der ersten und zweiten Rückkoppelschleifen ist, wobei ein Quantisierer basierend auf dem intermediären Signal u(k) das Ausgangssignal y(k) bestimmt und wobei k die diskrete unabhängige Zeitvariable ist.

In der DE 199 37 246 A1 wurde ein kaskadierter Sigma-Delta-Modulator zum einen mit den Vorteilen der Stabilität im Betriebsverhalten und der einfacheren Realisierbarkeit eines kaskadierten Ansatzes und zum anderen mit den Vorteilen einer geringen Stufenanzahl einer Rückkoppelschleife höherer Ordnung vorgestellt. Durch das Einbringen einer zusätzlichen Logik kann die Anzahl der Signalzustände auf bis zu 2 - entsprechend 1 Bit - reduziert werden. Aufwendige Clipping-Schaltungen entfallen, ohne das die Stabilität der Schaltung gefährdet ist. Bedingt durch die Modularität der Schaltung kann eine bestehende Struktur eines Sigma-Delta-Modulators i-ter Ordnung durch Hinzufügen einer zusätzlichen Logik-Stufe in eine Schaltung i+1-ter Ordnung in einfacher Weise erweitert werden.

Durch die Kaskadierung mehrerer Modulatoren erster Ordnung wird in der verwendeten Zielfunktion das Quantisierungsrauschen im tiefen Frequenzbereich besonders stark bewertet. Um das Quantisierungsrauschen in den hohen Frequenzbereich zu transformieren, sind starke Schwankungen des quantisierten Signals im Zeitbereich notwendig. Die Möglichkeit hierfür ist beispielsweise bei einem zweistufiges Signal nicht gegeben und wird durch die Struktur entsprechend der DE 199 37 246 A1 unterdrückt. Als Folge hiervon wird zwar durch Kaskadierung die Rauschformung in der Ordnung erhöht, der Frequenzbereich mit einem bestimmten Signal-zu-Rauschabstand bei gegebener Messbandbreite erhöht sich aber insbesondere bei einem gewünschten relativ geringen Signal-zu-Rauschabstand nur begrenzt.

Der vorliegenden Erfindung liegt daher die Aufgabe zugrunde, bei Sigma-Delta-Modulatoren oder bei der Kaskadierung von Sigma-Delta-Modulatoren die Stabilität zu erhöhen und so Sigma-Delta-Modulatoren mit höherer Nutzsignalbandbreite zu generieren.

Diese Aufgabe wird durch einen Sigma-Delta-Modulator mit den Merkmalen nach Anspruch 1 gelöst. Ausgestaltungen und Weiterbildungen der Erfindung sind Gegenstand der Unteransprüche.

Erfindungsgemäß umfasst der Sigma-Delta-Wandler Mittel zur Erzeugung eines Laufzeitunterschiedes zwischen dem Ausgangssignal y(k) und dem Eingangssignal x(k).

Durch diesen Laufzeitunterschied zwischen x(k) und u(k) bzw. y(k) basiert das Ergebnis des Sigma-Delta-Modulators nicht ausschließlich auf dem Momentanwert von x(k), sondern es werden für die Entscheidung des Quantisierers für ein Ausgangssignal mehrere zeitlich verschobene Werte herangezogen. Dadurch ist die Entscheidung des Sigma-Delta-Modulators weniger willkürlich dem momentanen Zustand unterworfen und das Quantisierungsrauschen im Nutzband kann verringert werden. Dies führt zu einem stabileren Verhalten des Sigma-Delta-Wandlers, so dass mit steigender Stabilität auch Signale mit höherer Nutzsignalbandbreite verarbeitet werden können.

In Weiterbildung der Erfindung ist mindestens ein Verzögerungsglied zur Erzeugung eines Laufzeitunterschiedes zwischen dem Ausgangssignal y(k) und dem Eingangssignal x(k) vorgesehen, wobei das mindestens eine Verzögerungsglied einen Laufzeitunterschied von der diskreten Zeitvariable k abhängigen Taktzyklen hervorruft, wobei ein Taktzyklus die Differenz zwischen zwei aufeinanderfolgenden Zeitvariablen k und k-1 ist. Durch das Verzögerungsglied kann gesteuert werden, wie viele aufeinanderfolgende d.h. zeitlich verschobene Werte bei der Entscheidung des Quantisierers für ein Ausgangssignal einbezogen werden. Dies bedeutet, dass durch das Verzögerungsglied die zeitliche Mittelungstiefe variiert werden kann. Außerdem bleibt durch die Verwendung von Verzögerungsgliedern zur zeitlichen Verschiebung der Signale die Kausalität des Sigma-Delta-Modulators erhalten.

In der technischen Realisierung kann das mindestens eine Verzögerungsglied so angeordnet sein, dass das Eingangssignal x(k) vor Bildung des Differenzsignals aus Eingangssignal x(k) und Summensignal r(k) der ersten und zweiten Rückkoppelschleifen verzögert ist.

Mit Vorteil ist dem Quantisierer eine Bewertungseinheit vorgeschaltet, wobei dem Quantisierer das-Ergebnissignal p(k) aus der Bewertungseinheit als Eingangssignal zugeführt ist. Aus der Sicht des Sigma-Delta-Modulators wird die Entscheidung des Quantisierers somit nicht nur auf der Grundlage eines Momentanwertes, sondern auch auf "zukünftigen" oder "vergangenen" Werten getroffen; es findet eine Mittelung benachbarter Eingangswerte statt, so dass die Entscheidung des Sigma-Delta-Modulators nicht den Spitzenwerten momentaner Zustände unterworfen ist. Die Mittelung in der Bewertungseinheit kann entsprechend der gewünschten Ausgestaltung des Sigma-Delta-Modulators geeignet gewählt werden. Die durch Mittelung geglätteten Spitzenwerte führen im spektralen Bereich zu einer Einschränkung des Quantisierungsrauschens auf einen kleineren spektralen Bereich, da durch die Mittelung die im zeitlichen Verlauf schnell veränderlichen Werte (große Frequenz) neu bewertet werden. Den Nutzsignalen steht somit spektral eine höhere Nutzbandbreite zur Verfügung, die nicht durch die spektralen Einflüsse des Quantisierungsrauschens gestört wird. Die Mittelung des Prädiktors führt also zu einer Reduzierung des Quantisierungsrauschens, da die Spitzenwerte geglättet werden, und diese Reduzierung des Quantisierungsrauschens impliziert eine höhere Nutzsignalbandbreite. Die Bewertungseinheit kann auch als Prädiktor bezeichnet werden.

Insbesondere kann die Bewertungseinheit Eingänge für das Eingangssignal x(k), das intermediäre Signal u(k) und das Ausgangssignal y(k) und einen Ausgang für das Ergebnissignal p(k) umfassen. Durch diese Eingänge ist es möglich, den Bewertungsalgorithmus der Bewertungseinheit von allen in der Regel in einem Sigma-Delta-Modulator zur Verfügung stehenden Parametern abhängig zu machen. Diese Parameter hängen insbesondere von der spektralen Formung der Rückkoppelsignale durch Filter ab, die entsprechend der gewünschten Ausgestaltung des Sigma-Delta-Modulators gewählt werden können. Der Bewertungsalgorithmus kann auch als Prädiktionsalgorithmus bezeichnet werden.

In Weiterbildung der Erfindung bildet der Quantisierer sein Eingangssignal p(k) auf ein Ausgangssignal y(k) mit vier, vorzugsweise zwei Signalzuständen ab. Die Stabilität des erfindungsgemäßen Sigma-Delta-Modulators ist auch bei einer geringen Anzahl von Signalzuständen des Ausgangssignals erhöht. Die maximale Reduktion der Signalzustände auf nur zwei Ausgangssignalzustände führt bei den bekannten Sigma-Delta-Modulatoren besonders häufig und ausgeprägt zu Instabilitäten, so dass die maximale Reduktion der Signalzustände des Ausgangssignals somit der effektivste Anwendungsfall der vorliegenden Erfindung ist.

Mit besonderem Vorteil sind mindestens zwei Sigma-Delta-Modulatoren kaskadiert angeordnet, wobei mindestens eine Kaskadestufe einen Sigma-Delta-Modulator mit Bewertungseinheit bzw. Prädiktor umfasst. Die Sigma-Delta-Modulatoren der Kaskade können insbesondere derart angeordnet sein, dass in dem Sigma-Delta-Modulator der Kaskadestufe i, mit $1 \leq i \leq$ (Anzahl der Kaskadestufen minus eins), das Differenzsignal ausgekoppelt ist und in der Kaskadestufe i+1 als Eingangssignal verwendet ist. Durch die Kaskadierung der Sigma-Delta-Modulatoren kann eine strukturbedingte ebenfalls höhere Stabilität des Sigma-Delta-Wandlers erreicht werden. Desweiteren erlauben kaskadierte Sigma-Delta-Wandler eine Erhöhung der maximalen Aussteueramplitude des Eingangssignals x(k). Neben einer erhöhten Stabilität im Betriebsverhalten führt die Kaskadierung zu einer einfacheren Realisierbarkeit, da aufgrund der Kaskadierung die Ordnung des Sigma-Delta-Modulators reduziert werden kann. Der Ausbau eines Sigma-Delta-Modulators mit i Kaskadestufen zu einem Sigma-Delta-Modulators mit i+1 Kaskadestufen, erfolgt durch einfaches erweitern um eine Kaskadestufe ohne Abänderung der Struktur vorhergehender Stufen.

Die erfindungsgemäßen Sigma-Delta-Modulatoren können grundsätzlich in allen geeigneten Sigma-Delta-Wandlern eingesetzt werden.

Einerseits können die erfindungsgemäßen Sigma-Delta-Modulatoren zur Digital-zu-Analog Wandlung verwendet werden. In diesem Fall umfassen die Sigma-Delta-Wandler zur Digital-zu-Analog Wandlung einen wie oben beschriebenen Sigma-Delta-Modulator nach der Erfindung und nachgeschaltet einen Digital-zu-Analog Wandler.

Andererseits können die erfindungsgemäßen Sigma-Delta-Modulatoren auch für die Analog-zu-Digital Wandlung eingesetzt werden. In diesem Fall umfassen die Sigma-Delta-Wandler zur Analog-zu-Digital Wandlung einen Analog-zu-Digital Wandler und diesem nachgeschaltet einen wie oben beschriebenen Sigma-Delta-Modulator nach der Erfindung. In diesem Fall kann das Laufzeitglied beispielsweise in SC-Technologie (Switched Capacitor) ausgeführt werden.

Im Hinblick auf eine kostengünstige und technisch flexible Herstellungsart kann der Sigma-Delta-Wandler in CMOS-Technik (Complementary Metal-Oxide-Silicon) hergestellt sein. Dies gilt sowohl für die Digital-zu-Analog Wandlung als auch für die Analog-zu-Digital Wandlung.

Die erfindungsgemäßen Sigma-Delta-Wandler zur Digital-zu-Analog Wandlung als auch zur Analog-zu-Digital Wandlung eignen sich hervorragend zur Verwendung in einem Funkkommunikationssystem. Insbesondere wird der Sigma-Delta-Wandler zur Digital-zu-Analog Wandlung in Funkkommunikations-Sendeeinrichtungen als auch zur Analog-zu-Digital Wandlung in Funkkommunikations-Empfangseinrichtungen benutzt.

Die Erfindung wird im folgenden an Hand von Ausführungsbeispielen näher erläutert.

Hierbei zeigen:

Fig.1: einen Sigma-Delta-Modulator nach dem Stand der Technik,

Fig.2: einen erfindungsgemäßen Sigma-Delta-Modulator mit Bewertungseinheit,

Fig.3: einen kaskadierten Sigma-Delta-Modulator nach der Erfindung,

Fig.4: ein Beispiel eines Entscheidungsalgorithmus nach dem Stand der Technik,

Fig.5: ein Beispiel eines entsprechenden Entscheidungsalgorithmus nach der vorliegenden Erfindung.

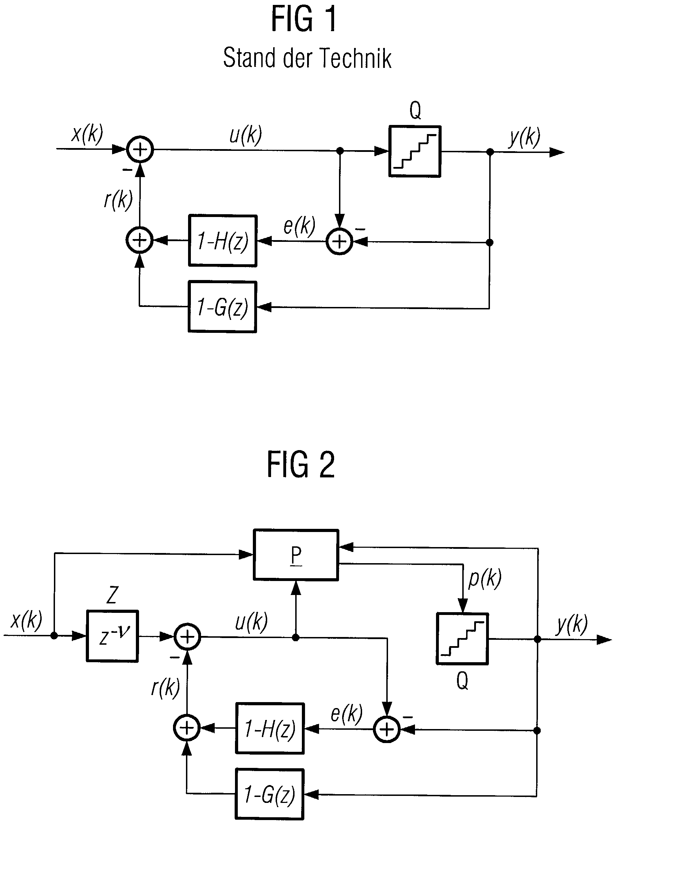

In Fig. 1 ist der Aufbau eines Sigma-Delta-Modulators nach dem Stand der Technik dargestellt. Durch die beiden Filter 1-$H(z)$ und 1-$G(z)$ wird das Nutzsignal $x(k)$ entsprechend der Signalübertragungsfunktion

$$STF(z) = \frac{1}{G(z)}$$

und das Rauschen e(k) des Quantisierers Q, welches sich aus dem Differenzsignal des Ausgangssignals y(k) und des intermediären Eingangssignals u(k) des Quantisierers ergibt, entsprechend der Rauschübertragungsfunktion

$$NTF(z) = \frac{H(z)}{G(z)}$$

spektral geformt. Das intermediäre Signal u(k) ergibt sich dabei als Differenzsignal aus dem Eingangssignals x(k) und dem rückgekoppelten Summensignal r(k) aus dem mit 1-G(Z) geformten Nutzsignal y(k) und dem mit 1-H(z) geformten Rauschsignal e(k) des Quantisieres Q.

Wesentlich ist jetzt, dass die Entscheidung des Quantisierers Q auf der Grundlage des Momentanwertes des intermediären Signals $u(k)$ und damit $x(k)$ erfolgt. Bei höherer Ordnung des Sigma-Delta-Modulators und schlechter Wahl der Rauschübertragungsfunktion führt dies zu signifikanten Instabilitäten.

Erfindungsgemäß wird nun der Entscheidungsalgorithmus der Sigma-Delta-Modulatoren durch eine Entscheidungseinheit - im folgenden als Prädiktor P bezeichnet - mit Prädiktionsalgorithmus erweitert, was in Fig. 2 ausgeführt ist. Hierbei wird das Eingangssignal $x(k)$ um eine bestimmte Zeit verzögert, was durch das Verzögerungsglied Z dargestellt ist. Das Verzögerungsglied Z bewirkt eine v-fache Verzögerung um den Zeittakt z$^{-1}$ und ist daher mit z$^{-v}$ symbolisiert. Das nicht verzögerte Eingangssignal x(k), sowie das zeitverzögerte intermediäre Signal u(k) und Ausgangssignal y(k) des Quantisierers Q werden dem Prädiktor P und damit dem Prädiktionsalgorithmus zugeführt, dessen Ausgangssignal p(k) die durch den Quantisierer Q angenommenen Zustände bestimmt.

Der Vorteil dieses Vorgehens gegenüber dem Stand der Technik ist, dass aus der Sicht des Sigma-Delta-Algorithmus die Entscheidungen des Quantisierers Q auf der Grundlage auch zukünftiger Daten getroffen werden. Die Kausalität bleibt durch das in Fig. 2 dargestellte Verzögerungsglied Z gewährleistet. Dadurch sind die Entscheidungen weniger willkürlich dem momentanen Zustand unterworfen und das Quantisierungsrauschen im Nutzband kann verringert werden.

Die erfindungsgemäße Anwendung des Prädiktionsalgorithmus soll nun anhand von zwei Beispielen dargestellt werden.

In dem ersten Anwendungsfall wird von einem bekannten Sonderfall eines in Fig. 1 dargestellten Sigma-Delta-Modulators ausgegangen: $G(z)=1$ und $H(z)=(1-z^{-1})^3$. Diese Wahl der Rauschübertragungsfunktion führt zu einer Fehlfunktion des konventionellen Sigma-Delta-Modulators.

Mit $v=2$ der Anzahl der verschobenen Zeittakte und $1-H(z)=3z^{-1}-3z^{-2}+z^{-3}$ lassen sich folgende Prädiktionswerte berechnen:

$$u(k) = x(k\text{-}2)+3e(k\text{-}1)\text{-}3e(k\text{-}2)+e(k\text{-}3)$$

$$\hat{u}_{+1}(k) = x(k\text{-}1)+3u(k)\text{-}3e(k\text{-}1)+e(k\text{-}2)$$

$$\hat{u}_{+2}(k) = x(k)+3\hat{u}_{+1}(k)\text{-}3u(k)+e(k\text{-}1)$$

Mit

$$e(k) = u(k)\text{-}y(k)$$

$$e(k+1) = \hat{u}_{+1}(k)\text{-}3y(k)\text{-}y(k+1)$$

$$e(k+2) = \hat{u}_{+2}(k)\text{-}6y(k)\text{-}3y(k+1)\text{-}y(k+2)$$

geht so in den Entscheidungsprozeß nicht nur der aktuelle Ausgangswert des Sigma-Delta-Modulators ein, sondern vielmehr auch der Wertebereich zukünftiger Eingangssignale x(k) und Entscheidungen. Bei einem zweistufigen Ausgangssignal y(k) des Sigma-Delta-Modulators kann beispielsweise

$$y(k) = \begin{cases} 1 & \text{für} \quad \hat{u}_{+2}(k) \geq 0 \\ -1 & \text{für} \quad \hat{u}_{+2}(k) < 0 \end{cases}$$

als Grundlage für die Entscheidung genommen werden. $y(k)$ wird so gewählt, dass $y(k+1)$ und $y(k+2)$ es in den nächsten Zeitschritten größtenteils wieder kompensieren können. Damit wird der vorher instabile Sigma-Delta-Modulator stabilisiert. Die wesentliche Modifikation des Sigma-Delta-Modulators zu dem bekannten Ansatz besteht in dem neu eingefügten Laufzeitunterschied des Eingangssignals zu dem Ausgangssignal. In dem oben betrachteten Beispiel sind dies 2 Zeittakte ($v=2$).

Für $\hat{u}_{+2}(k)$ kann eine Rekursionsformel hergeleitet werden, die eine effiziente Implementierung ermöglicht:

$$\hat{u}_{+2}(k)=x(k)+3\hat{u}_{+2}(k\text{-}1)\text{-}3\hat{u}_{+2}(k\text{-}2)+\hat{u}_{+2}(k\text{-}3)+10y(k\text{-}1)\text{-}15y(k\text{-}2)+6y(k\text{-}3)$$

Für ein dreistufiges Signal mit drei Signalzuständen 1, 0, -1 ist

$$y(k) = \begin{cases} 1 & \text{für} \quad (\hat{u}_{+1}(k) \geq 1) \wedge (\hat{u}_{+2}(k) \geq 0) \\ -1 & \text{für} \quad (\hat{u}_{+1}(k) < -1) \wedge (\hat{u}_{+2}(k) < 0) \\ 0 & \text{sonst} \end{cases}$$

vorteilhaft.

Problematisch bleibt trotz Prädiktion P die maximale Aussteueramplitude des Sigma-Delta-Modulators, die bei dem oben angegebenen Beispiel bei 0.5 liegt. Aus diesem Grund wurde in der DE 199 37 246 A1 ein Sigma-Delta-Modulator mit den Vorteilen der Stabilität im Betriebsverhalten und der einfacheren Realisierbarkeit eines kaskadierten Ansatzes mit den Vorteilen einer geringen Stufenanzahl einer Rückkoppelschleife höherer Ordnung vorgestellt. Durch den in dieser Erfindungsmeldung eingebrachten Einsatz eines Prädiktionsalgorithmus in mindestens einer Kaskadenstufe treten die oben beschriebenen Schwankungen des quantisierten Signals im Zeitbereich nur in einem reduzierten Umfang auf, die Bandbreite der letzten Kaskadenstufen erweitert sich.

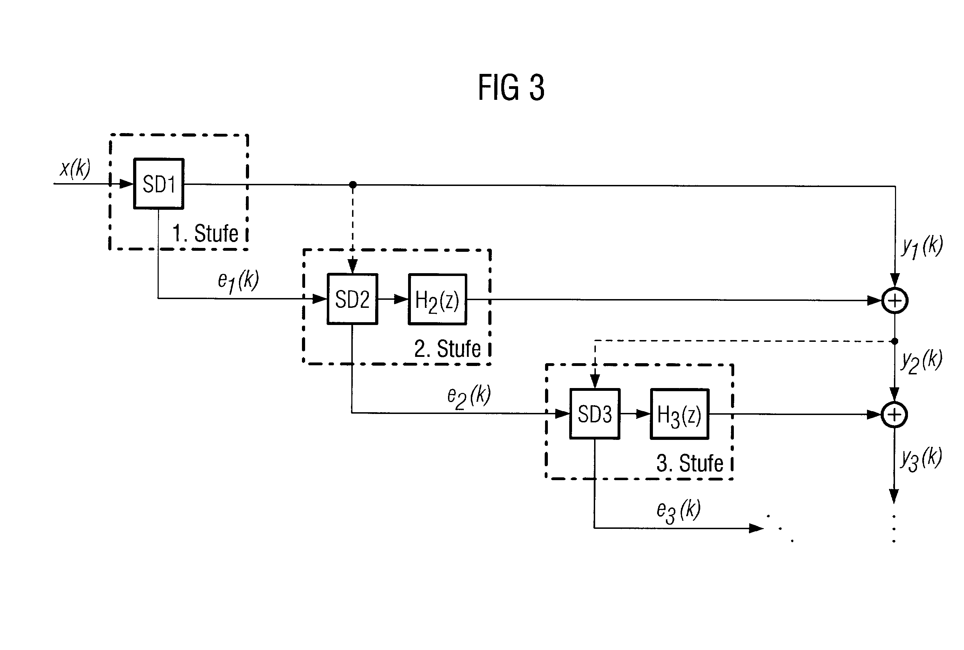

In Fig. 3 wird ein konditionierter kaskadierter Sigma-Delta-Algorithmus dargestellt. Der Quantisierungsfehler eines Modulators wird dabei dem nächsten als Eingangssignal zur Verfügung gestellt.

Im folgenden wird anhand des Anwendungsfall eines 1-Bit Ausgangssignals bei einem Sigma-Delta-Modulator dritter Ordnung die Wirkungsweise des konditionierten kaskadierten Sigma-Delta-Modulators aufgezeigt. Die im folgenden betrachtete dritte Stufe des konditionierten kaskadierten Sigma-Delta-Modulators erhält als Eingangssignal $e_2(k)$ und ist aus Stabilitätsgründen in dem in DE 199 37 246 A1 dargestellten Anwendungsbeispiel lediglich mit einem dreistufigen Sigma-Delta-Ausgangssignal verwendet worden.

$$\hat{y}_3(k) = \begin{cases} \hat{y}_3(k)+1 & \text{für} \quad ((\tilde{x}_3(k) \geq 1) \wedge (y_2(k) - \tilde{y}_3(k-1) < 1) \wedge (y_2(k+1) = 1) \\ & \qquad \wedge (\hat{y}_3(k) < 1)) \wedge ((1 > \tilde{x}_3(k) \geq -1) \wedge (y_2(k) - \tilde{y}_3(k-1) \\ & \qquad < 1) \wedge (y_2(k+1) = 1) \wedge (\hat{y}_3(k) < 0)) \\ \hat{y}_3(k)-1 & \text{für} \quad ((\tilde{x}_3(k) < -1) \wedge (y_2(k) - \tilde{y}_3(k-1) > -1) \wedge (y_2(k+1) \\ & \qquad < 1) \wedge (\hat{y}_3(k) > -1)) \wedge ((1 > \tilde{x}_3(k) \geq -1) \wedge (y_2(k) - \\ & \qquad \tilde{y}_3(k-1) > -1) \wedge (y_2(k+1) < 1) \wedge (\hat{y}_3(k) > 0)) \\ \hat{y}_3(k) & \text{sonst} \end{cases}$$

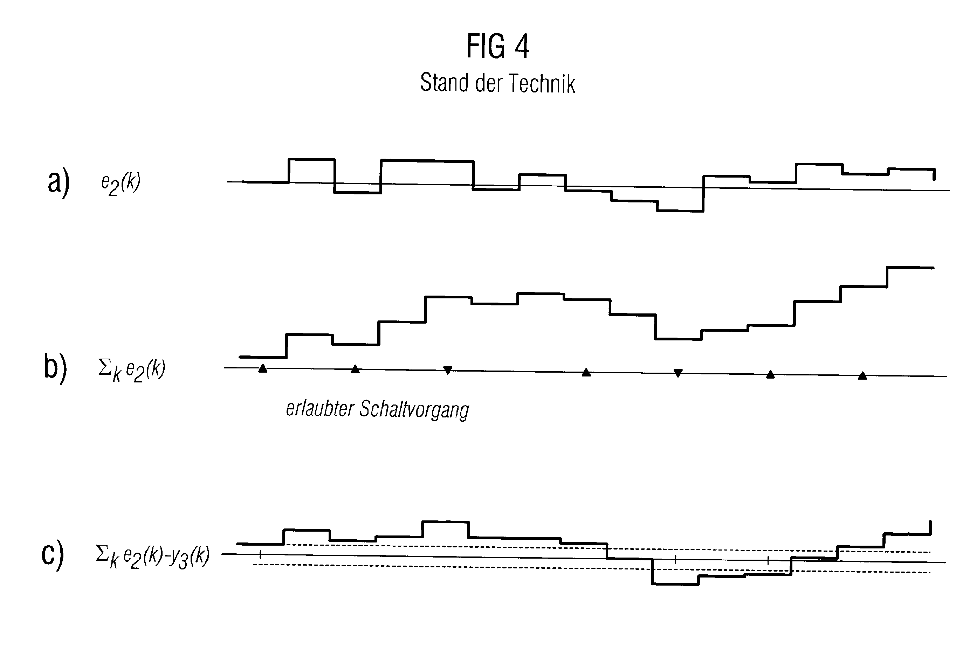

Fig. 4 verdeutlicht das hierbei auftretende Problem für den in DE 199 37 246 A1 dargestellten Anwendungsfall. In Fig. 4 a) ist ein beispielhafter Verlauf des Eingangssignals der dritten Stufe dargestellt. Dieses Signal wird durch den im Sigma-Delta-Modulator implizit enthaltenen digitalen Integrator aufsummiert ($\Sigma_k e_2(k)$ in Fig. 4 b)). Man erkennt, dass große Zahlenwerte des integrierten Signals auftreten können. Idealerweise sollte jetzt das Entscheiderausgangssignal $y_3(k)$ diesem Verhalten entgegenwirken. Durch die Nebenbedingung, dass das Ausgangssignal $y(k)$ zweistufig sein soll, sind aber nicht alle Zeitpunkte für einen Wechsel des Zustandes von $y_3(k)$ erlaubt. Als Beispiel sind in Fig. 4 b) die erlaubten Umschaltzeitpunkte durch Pfeile angedeutet. Ein Pfeil nach oben deutet an, dass der Wechsel von $y_3(k)$=-2 auf $y_3(k)$=0 bzw. von $y_3(k)$=0 auf $y_3(k)$=2 erlaubt ist. Dementsprechend weist ein Pfeil nach unten darauf hin, dass der Wechsel von $y_3(k)$=2 auf $y_3(k)$=0 bzw. von $y_3(k)$=0 auf $y_3(k)$=-2 erlaubt ist.

Fig. 4 c) zeigt im Signal $\Sigma_k e_2(k)$-$y_2(k)$ das Verhalten, wenn die möglichen Schaltvorgänge günstig auftreten. Das Fehlersignal der dritten Stufe wird erkennbar abgesenkt. Im Gegensatz dazu verdeutlicht Fig. 4 c) den Fall, dass der Schaltvorgang erst verzögert erlaubt ist und dadurch eine starke Überhöhung in dem Fehlersignal auftritt.

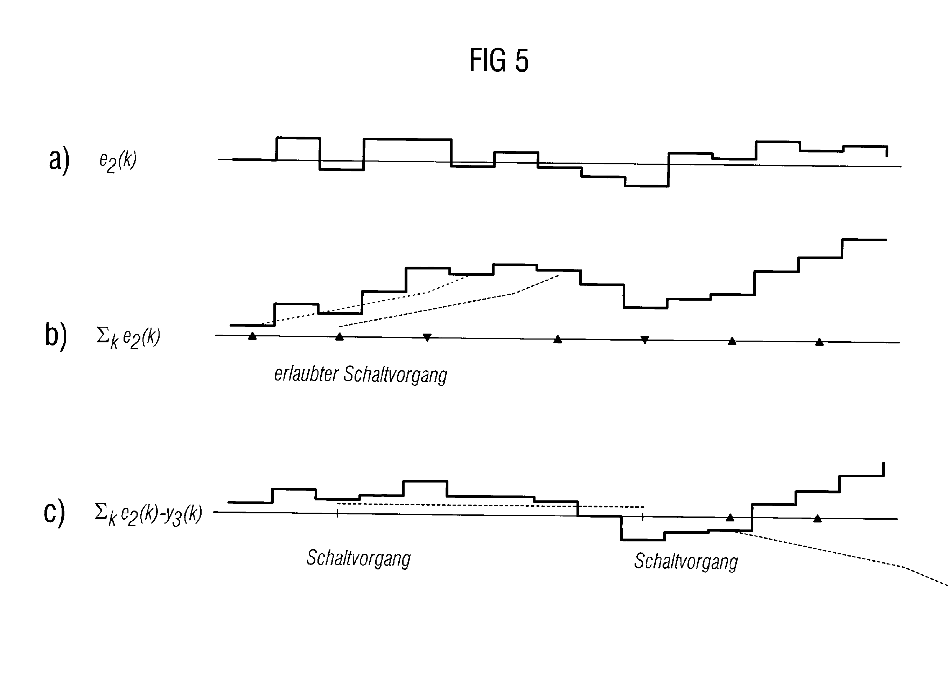

In FiG. 5 wird von dem selben Ausgangssignal der zweiten Stufe und den selben Entscheidungszeitpunkten wie in Fig. 4 ausgegangen. Der Entscheider arbeitet jetzt allerdings mit einem Prädiktionsalgorithmus:

$$\tilde{x}_{3p}(k) \quad = \quad \tilde{x}_3(k) + e_2(k+1) - \hat{y}_3(k-1)$$

$$\tilde{x}_{3p1}(k) \quad = \quad \tilde{x}_{3p}(k) + e_2(k+2) - \hat{y}_3(k-1)$$

$$\tilde{x}_{3p2}(k) \quad = \quad \tilde{x}_{3p1}(k) + e_2(k+3) - \hat{y}_3(k-1)$$

$$\tilde{x}_{3p3}(k) \quad = \quad \tilde{x}_{3p2}(k) + e_2(k+4) - \hat{y}_3(k-1)$$

$$\hat{y}_3(k) = \begin{cases} \hat{y}_3(k)+1 & \text{für} & ((x_3(k) \geq 1) \wedge (x_{3p}(k) \geq 1) \wedge (x_{3p1}(k) \geq 1) \wedge (x_{3p2}(k) \geq 1) \\ & & \wedge (x_{3p3}(k) \geq 2) \wedge (y_2(k) - \tilde{y}_3(k-1) < 1) \wedge (y_2(k+1) = 1) \\ & & \wedge (\hat{y}_3(k) < 1)) \wedge ((1 > x_3(k) \geq -1) \wedge (y_2(k) - \tilde{y}_3(k-1) < 1) \\ & & \wedge (y_2(k+1) = 1) \wedge (\hat{y}_3(k) < 0)) \\[2mm] \hat{y}_3(k)-1 & \text{für} & ((x_3(k) < -1) \wedge (x_{3p}(k) < -1) \wedge (x_{3p1}(k) < -1) \wedge (x_{3p2}(k) < -1) \\ & & \wedge (x_{3p3}(k) < -2) \wedge (y_2(k) - \tilde{y}_3(k-1) > -1) \wedge (y_2(k+1) < 1) \\ & & \wedge (\hat{y}_3(k) > -1)) \wedge ((1 > x_3(k) \geq -1) \wedge (y_2(k) - \tilde{y}_3(k-1) > -1) \\ & & \wedge (y_2(k+1) < 1) \wedge (\hat{y}_3(k) > 0)) \\[2mm] \hat{y}_3(k) & \text{sonst} \end{cases}$$

Damit werden die möglichen Überhöhungen in dem Fehlersignal 1 im vornherein festgestellt und so vermieden. In Fig. 5 b) und 5 c) sind die Schwellen für den integrierten Fehler gestrichelt dargestellt, die überschritten werden müssen, damit ein erlaubter Schaltvorgang auch durchgeführt wird.

**Patentansprüche**

1.   Sigma-Delta-Modulator zur Wandlung von digitalen Eingangssignalen x(k) umfassend
eine erste Rückkoppelschleife eines spektral geformten Ausgangssignals y(k) des Sigma-Delta-Modulators und eine zweite Rückkoppelschleife eines spektral geformten Differenzsignals e(k) aus einem intermediären Signal u(k) und dem Ausgangssignal y(k),
wobei das intermediäre Signal u(k) das Differenzsignal des Eingangssignals x(k) und dem Summensignal r(k) der ersten und zweiten Rückkoppelschleifen ist,
wobei ein Quantisierer (Q) basierend auf dem intermediären Signal u(k) das Ausgangssignal y(k) bestimmt,
wobei k die diskrete unabhängige Zeitvariable ist,
**dadurch gekennzeichnet,**
**dass** der Sigma-Delta-Wandler Mittel (Z) zur Erzeugung eines Laufzeitunterschiedes zwischen dem Ausgangssignal y(k) und dem Eingangssignal x(k) umfasst.

2.   Sigma-Delta-Modulator nach Anspruch 1,
**dadurch gekennzeichnet,**
**dass** mindestens ein Verzögerungsglied (Z) zur Erzeugung eines Laufzeitunterschiedes zwischen dem Ausgangssignal y(k) und dem Eingangssignal x(k) vorgesehen ist, wobei das mindestens eine Verzögerungsglied (Z) einen Laufzeitunterschied von der diskreten Zeitvariable k abhängigen Taktzyklen hervorruft, wobei ein Taktzyklus die Differenz zwischen zwei aufeinanderfolgenden Zeitvariablen k und k-1 ist.

3.   Sigma-Delta-Modulator nach Anspruch 2,
**dadurch gekennzeichnet,**
**dass** das mindestens eine Verzögerungsglied (Z) so angeordnet ist, dass das Eingangssignal x(k) vor Bildung des Differenzsignals aus Eingangssignal x(k) und Summensignal r(k) der ersten und zweiten Rückkoppelschleifen verzögert ist.

4.   Sigma-Delta-Modulator nach Anspruch 3,
**dadurch gekennzeichnet,**
**dass** dem Quantisierer (Q) eine Bewertungseinheit (P) vorgeschaltet ist, wobei dem Quantisierer (Q) das Ergebnissignal p(k) aus der Bewertungseinheit (P) als Eingangssignal zugeführt ist.

5.   Sigma-Delta-Modulator nach Anspruch 4,
**dadurch gekennzeichnet,**
**dass** die Bewertungseinheit (P) Eingänge für das Eingangssignal x(k), das intermediäre Signal u(k) und das Ausgangssignal y(k) und einen Ausgang für das Ergebnissignal p(k) umfassen.

**6.** Sigma-Delta-Modulator nach einem der Ansprüche 4 oder 5,
**dadurch gekennzeichnet,**
**dass** der Quantisierer (Q) sein Eingangssignal p(k) auf ein Ausgangssignal y(k) mit vier, vorzugsweise zwei Signalzuständen abbildet.

**7.** Sigma-Delta-Modulator nach einem der Ansprüche 4 bis 6,
**dadurch gekennzeichnet,**
**dass** mindestens zwei Sigma-Delta-Modulatoren kaskadiert angeordnet sind,
wobei mindestens eine Kaskadestufe einen Sigma-Delta-Modulator mit Bewertungseinheit (P) umfasst.

**8.** Sigma-Delta-Modulator nach Anspruch 7,
**dadurch gekennzeichnet,**
**dass** die Sigma-Delta-Modulatoren der Kaskade derart angeordnet sind,
**dass** in dem Sigma-Delta-Modulator der Kaskadestufe i, mit $1 \leq i \leq$ (Anzahl der Kaskadestufen minus eins), das Differenzsignal ($e_1(k)$, $e_2(k)$, $e_3(k)$) ausgekoppelt ist und in der Kaskadestufe i+1 als Eingangssignal verwendet ist.

**9.** Sigma-Delta-Wandler zur Digital-zu-Analog Wandlung umfassend einen Sigma-Delta-Modulator nach einem der Ansprüche 1 bis 9 und einen Digital-zu-Analog Wandler.

**10.** Sigma-Delta-Wandler zur Analog-zu-Digital Wandlung umfassend einen Analog-zu-Digital Wandler und einen Sigma-Delta-Modulator nach einem der Ansprüche 1 bis 9.

**11.** Sigma-Delta-Wandler nach Anspruch 9 oder 10,
**dadurch gekennzeichnet,**
**dass** der Sigma-Delta-Wandler in CMOS-Technik hergestellt ist.

**12.** Verwendung eines Sigma-Delta-Modulators und/oder eines Sigma-Delta-Wandlers nach einem der vorangehenden Ansprüche in einem Funk-Kommunikationssystem.

# FIG 1

Stand der Technik

# FIG 2

FIG 3

# FIG 4
### Stand der Technik

a)    $e_2(k)$

b)    $\Sigma_k\, e_2(k)$

*erlaubter Schaltvorgang*

c)    $\Sigma_k\, e_2(k) - y_3(k)$

EP 1 333 583 A1

# FIG 5

a)    $e_2(k)$

b)    $\Sigma_k\, e_2(k)$

erlaubter Schaltvorgang

c)    $\Sigma_k\, e_2(k) - y_3(k)$

Schaltvorgang       Schaltvorgang

EP 1 333 583 A1

**Europäisches Patentamt**

# EUROPÄISCHER RECHERCHENBERICHT

Nummer der Anmeldung

EP 01 13 0334

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 5 055 843 A (GANESAN APPARAJAN ET AL) 8. Oktober 1991 (1991-10-08) * Spalte 4, Zeile 62 - Spalte 5, Zeile 20; Abbildungen 5,6 * ----- | 1 | H03M7/00 |

**RECHERCHIERTE SACHGEBIETE (Int.Cl.7)**

H03M

Der vorliegende Recherchenbericht wurde für alle Patentansprüche erstellt

| Recherchenort | Abschlußdatum der Recherche | Prüfer |
|---|---|---|
| DEN HAAG | 6. Juni 2003 | Beindorff, W |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 01 13 0334

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-06-2003

| Im Recherchenbericht angeführtes Patentdokument | Datum der Veröffentlichung | Mitglied(er) der Patentfamilie | Datum der Veröffentlichung |
|---|---|---|---|
| US 5055843 A | 08-10-1991 | DE 69107059 D1 | 09-03-1995 |
| | | DE 69123366 D1 | 09-01-1997 |
| | | EP 0513241 A1 | 19-11-1992 |
| | | EP 0586021 A1 | 09-03-1994 |
| | | JP 5505287 T | 05-08-1993 |
| | | US 5311181 A | 10-05-1994 |
| | | WO 9111863 A1 | 08-08-1991 |

Für nähere Einzelheiten zu diesem Anhang : siehe Amtsblatt des Europäischen Patentamts, Nr.12/82

EPO FORM P0461